# EUROPÄISCHE PATENTSCHRIFT

(11) **EP 2 773 586 B1**
(45) Veröffentlichungstag und Bekanntmachung des Hinweises auf die Patenterteilung: **24.03.2021**
(21) Anmeldenummer: 12790454.8
(22) Anmeldetag: 02.11.2012
(51) Int. Cl.: B81B 7/02, B81C 1/00, G01D 5/12

(54) **MIKROMECHANISCHES ELEMENT, BAUELEMENT MIT EINEM MIKROMECHANISCHEN ELEMENT UND VERFAHREN ZUM HERSTELLEN EINES BAUELEMENTS**
MICROMECHANICAL ELEMENT, COMPONENT HAVING A MICROMECHANICAL ELEMENT, AND METHOD FOR PRODUCING A COMPONENT
ÉLÉMENT MICROMÉCANIQUE, COMPOSANT MUNI D'UN ÉLÉMENT MICROMÉCANIQUE ET PROCÉDÉ DE FABRICATION D'UN COMPOSANT

(30) Priorität: 03.11.2011 DE 102011085727
(43) Veröffentlichungstag der Anmeldung: 10.09.2014
(73) Patentinhaber: Continental Teves AG & Co. OHG, 60488 Frankfurt am Main (DE)
(72) Erfinder: GÜNTHNER, Stefan, 60439 Frankfurt am Main (DE); SCHMID, Bernhard, 61169 Friedberg (DE)
(74) Vertreter: Continental Corporation
(86) Internationale Anmeldenummer: PCT/EP2012/071724
(87) Internationale Veröffentlichungsnummer: WO 2013/064634

(56) Entgegenhaltungen:
- EP-A1- 1 775 259
- JP-A- 2010 054 212
- US-A1- 2010 028 618
- US-A1- 2011 227 173

## Beschreibung

Die Erfindung betrifft ein mikromechanisches Element, ein Bauelement mit einem mikromechanischen Element und ein Verfahren zum Herstellen eines Bauelements.

In aktiven und passiven Sicherheitssystemen heutiger Automobile werden zahlreiche Sensorinformationen, wie Raddrehzahl, Lenkwinkeleinschlag, Beschleunigungen und Drehgeschwindigkeiten benötigt. So verwendet beispielsweise eine Airbag-Funktion Beschleunigungsinformationen entlang einer Längsachse und entlang einer Querachse des Fahrzeugs mit einem Messbereich bis zu 500-1000 m/s². Für das elektronische Stabilitätsprogramm hingegen werden Beschleunigungssensorinformationen im Bereich bis 20 m/s² benötigt zusätzlich zur Drehgeschwindigkeitmessung um die Hochachse des Fahrzeugs. Hierbei werden herkömmlich zur Messung der Beschleunigung für unterschiedliche Messbereiche separate Sensoren eingesetzt.

Eine weitere Vorgehensweise schlägt eine Integration von mehreren Sensoren zu einer Einheit vor. Es sind bereits Anordnungen mit Sensor-Integrationen auf einem einzelnen Chip bekannt. In EP 2 081 030 A2 und der US 2010/028618 A1 wird jeweils eine Kombination eines Beschleunigungssensors mit einem Drehratensensor beschrieben. WO 2008/026331 A1 zeigt einen Beschleunigungssensor mit erweitertem Messbereich.

EP 1775259 A1 beschreibt ein mikromechanisches Element zur Messung von mindestens zwei physikalischen Messgrößen (Druck und Beschleunigung) aufweisend
- ein mikromechanisches Element mit einer Mehrzahl von Einzelsensorelementen, wobei mit einem ersten Einzelsensorelement eine erste physikalische Messgröße messbar ist und mit einem zweiten Einzelsensorelement eine zweite physikalische Messgröße messbar ist;
- mindestens eine Regelungselektronikeinheit, die mit dem mikromechanischen Element elektrisch verbindbar ist;
- wobei das mikromechanische Element und die Regelungselektronikeinheit in einem gemeinsamen Gehäuse (21) angeordnet sind.

Es ist jedoch bisher problematisch, mit einem einzelnen mikromechanischen Element Messungen verschiedener Messgrößen, wie Drehgeschwindigkeit und Beschleunigung, durchzuführen.

Der Erfindung liegt die Aufgabe zugrunde, Lösungen vorzuschlagen, um unterschiedliche physikalische Messgrößen mit einer einzelnen Vorrichtung bereitstellen zu können.

Die Aufgabe wird durch die Merkmale der unabhängigen Ansprüche gelöst. Bevorzugte Weiterbildungen der Erfindung sind Gegenstand der abhängigen Ansprüche.

Der Erfindung liegt der Gedanke zugrunde, ein mikromechanisches Element, ein Bauelement mit einem mikromechanischen Element und ein Verfahren zur Herstellung des Bauelements bereitzustellen. Hierbei weist das mikromechanische Element, das Teil eines Bauelementes sein kann, eine Mehrzahl von Einzelsensorelementen auf, wobei die Einzelsensorelemente eines mikromechanischen Elementes in einem Gehäuse eines Bauelementes angeordnet sind und in hermetisch voneinander getrennten Bereichen angeordnet sind.

Ein erstes Einzelsensorelement ist ein Drehratensensorelement (1'a), ein zweites Einzelsensorelement ein Beschleunigungssensorelement (2'a) mit niedrigem Messbereich und ein drittes Einzelsensorelement ein Beschleunigungssensorelement (3'a) mit hohem Messbereich. Mit dem erfindungsgemäßen mikromechanischen Element können Sensoren zur Messung von Drehgeschwindigkeiten und Beschleunigungen mit erweitertem Messbereich bereitgestellt werden. Durch die Integration mehrerer Einzelsensorelemente innerhalb eines mikromechanischen Elementes können unterschiedliche physikalische Messgrößen, wie Beschleunigung, Geschwindigkeit, Drehrate, Druck, Temperatur und Winkel, wie Neigungswinkel, zeitlich gemessen werden.

Eine Kombination von Einzelsensorelementen, die physikalische Messgrößen unterschiedlicher Bereiche aufnehmen kann, erweitert den Messbereich der Einzelsensorelemente. Dies ist insbesondere bei der Messung einer Beschleunigung bei Fahrzeugen von Vorteil. Hierbei können geringe Beschleunigungswerte sowie hohe Beschleunigungswerte mit einer ähnlichen Präzision mit Hilfe eines einzelnen mikromechanischen Elementes innerhalb eines Bauelementes gemessen werden. Regelungseinheiten oder Regelungselektronikeinheiten, die ebenfalls in dem Bauelement angeordnet sind, können die erfassten Messwerte weiterverarbeiten.

Es kann somit mit einem einzelnen Bauelement oder Sensor die Messung von Drehgeschwindigkeiten und Beschleunigungen mit erweitertem Messbereich zur Verfügung gestellt werden. Eine Integration von Elementen auf einem einzelnen elektromechanischen Element oder Chip kann beispielsweise bereitgestellt werden, indem unterschiedliche mikromechanische Strukturen unter verschiedenen Gasdrücken auf einem Chip integriert werden, um unterschiedliche Messaufgaben wahrzunehmen. Hierbei ist es möglich, unterschiedliche Anforderungen mit Hilfe von unterschiedlich einstellbaren Drücken in dem Chip bereitzustellen.

Es ist auch möglich die erfindungsgemäßen Sensoren für die Messung der Längs- und Querbeschleunigung eines Fahrzeugs im niedrigen und im hohen Messbereich einzusetzen, sowie die Erfassung der Drehgeschwindigkeit um die Hochachse eines Fahrzeuges. Es kann durch die Integration der Sensoren innerhalb eines Bauteiles Platz und Kosten gespart werden.

Ferner ist es vorteilhaft, Drehraten- und Beschleunigungssensoren auf einer Einheit miteinander zu kombinieren, um für unterschiedliche Messaufgaben ein einzelnes Bauteil bereitzustellen. Dies ist möglich, da die Messungen von Drehzahl und Beschleunigung auf ähnlichen physikalischen Prinzipien beruhen können, was die Integration aller Sensoren in einem einzelnen mikromechanischen Element ermöglicht.

Auch ist es von Vorteil, wenn Herstellungsprozesse der Beschleunigungssensoren und der Drehratensensoren ähnlich ausgebildet werden, so dass durch eine Harmonisierung der Prozesse oder Verfahrensschritte bei der Herstellung der beiden Sensortypen dieselbe Technologieplattform verwendet werden kann.

Ferner ist es von Vorteil, dass die Integration eine Reduzierung der Kosten für die Aufbau- und Verbindungstechnik darstellt, da weniger Elemente verarbeitet werden müssen. Auch kann ein kombiniertes mikromechanisches Element kostengünstiger hergestellt werden, da Strukturen, wie z.B. Rahmen eingespart werden können. Schließlich ist der Platzbedarf eines einzelnen Elementes geringer im Vergleich zu einer Anordnung mit mehreren Elementen.

Auch können Crash-Situationen vorzeitig erkannt werden, wenn starkes und abruptes Bremsen, welches sich im niederen Beschleunigungsbereich abspielt, erkannt und in einem Airbag-Auslöseverfahren implementiert werden. Aufgrund von Signallaufzeit- und Phasenunterschieden zwischen getrennt arbeitenden, physikalisch unabhängigen Beschleunigungssensoren können sich Nachteile bei der Auslegung des Auslöseverfahrens ergeben. Diese Nachteile können nun mit Hilfe der vorgeschlagenen Anordnungen überwunden werden.

Weiterbildungen des Verfahrens können Verfahrensschritte sein, die die Merkmale der angegebenen Bauelemente gemäß den Unteransprüchen sinngemäß realisieren.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Es zeigt:
Fig. 1 eine herkömmliche Anordnung von Bauelementen;
Fig. 2 ein erstes Ausführungsbeispiel einer erfindungsgemäßen Anordnung; und
Fig. 3 eine Anordnung, die nicht Teil der Erfindung ist.

Es werden hierbei für identische oder ähnliche Elemente in den Figuren gleiche Bezugszeichen verwendet.

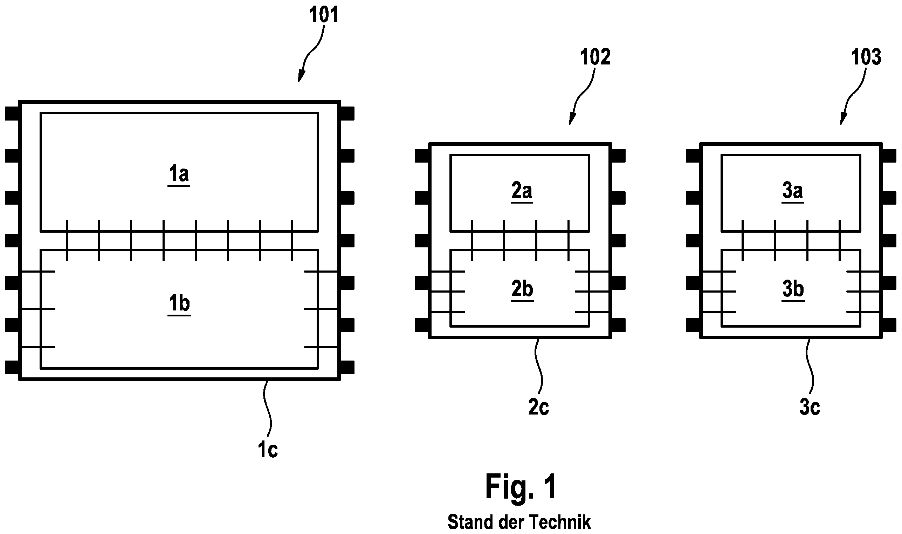

Fig. 1 zeigt eine herkömmliche Anordnung von Bauelementen 101, 102, 103. Im Falle mikromechanischer Sensoren sind hierbei üblicherweise ein mikromechanisches Drehratensensorelement 1a zusammen mit einer Regelungselektronikeinheit 1b in einem gemeinsamen Gehäuse 1c angeordnet. Ebenso ist ein Beschleunigungssensorelement mit niedrigem Messbereich 2a und ein Beschleunigungssensorelement mit hohem Messbereich 3a und entsprechender Regelungselektronik für den niedrigen Messbereich 2b und für den hohen Messbereich 3b verpackt und jeweils in einem gemeinsamen Gehäuse 2c bzw. 3c angeordnet. Es werden somit für drei Messaufgaben, nämlich der Messung einer niedrigen Beschleunigung, einer hohen Beschleunigung und einer Drehrate, drei einzelne Bauelemente 101, 102, 102 verwendet, in denen sich jeweils mikromechanische Elemente 1a, 1b bzw. 2a, 2b, bzw. 3a, 3b befinden.

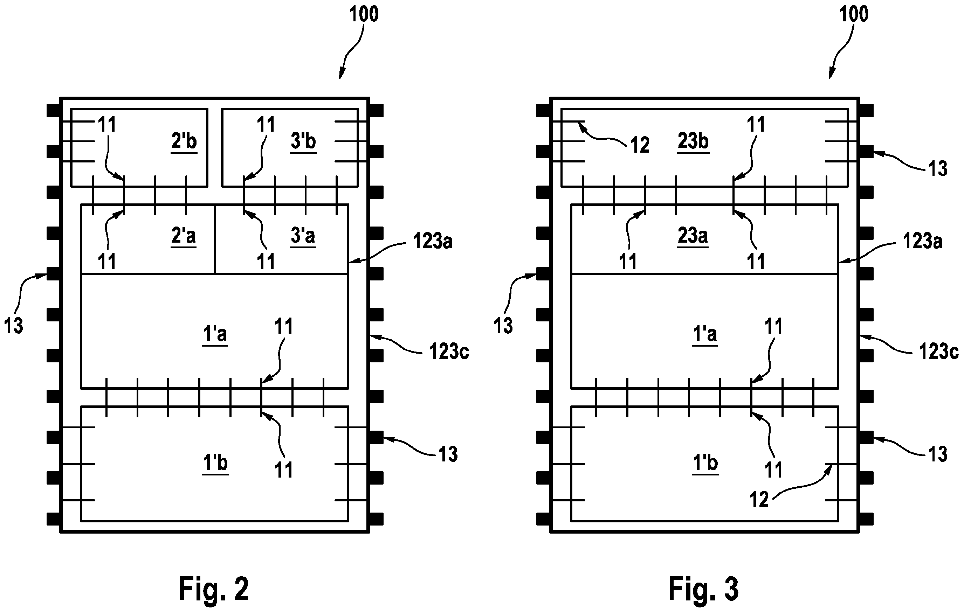

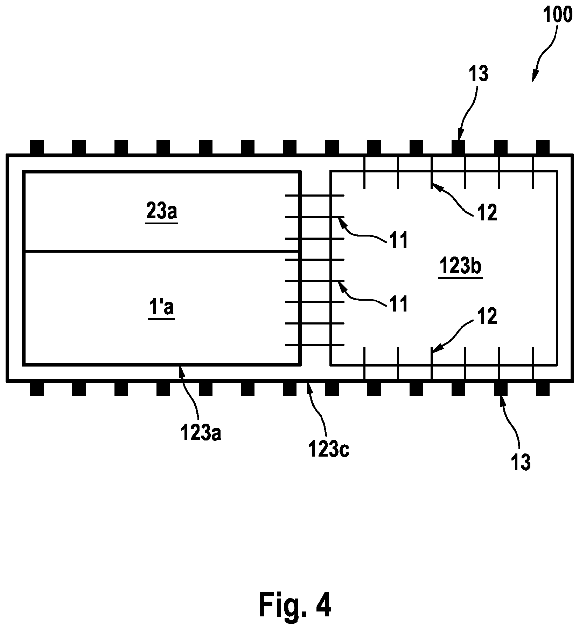

Fig. 2 zeigt ein erstes Ausführungsbeispiel einer erfindungsgemäßen Anordnung eines Bauelements 100. Hierbei weist ein einzelnes mikromechanisches Element 123a, hier ein Sensorelement in einem Chip, mehrere Einzelelemente 1'a, 2'a, 3'a auf. Die Einzelelemente 1'a, 2'a, 3'a können dabei voneinander hermetisch getrennte Bereiche innerhalb des gemeinsamen Chips 123a einnehmen, die unterschiedliche Drücke einschließen können. Die jeweilige Regelungselektronik ist auf separaten Einheiten 1'b, 2'b, 3'b angeordnet und ist mit dem Sensorelement 123a in einem gemeinsamen Gehäuse 123c untergebracht. Auf diese Weise kann eine Beschleunigungsmessung in einem großen Messbereich abgedeckt werden sowohl mit niedrigen wie auch hohen Beschleunigungswerten, wie beispielsweise von etwa 1 m/s² bis etwa 1000 m/s². Auch kann ein einzelnes Element einen solchen Messbereich abdecken, indem eine Beschleunigungssensoreinheit 23a bereitgestellt wird, wie in Fig. 3 und 4 gezeigt.

Fig. 3 zeigt ein mikromechanisches Element 123a, das nicht Teil der Erfindung ist, mit einem Drehratensensor 1'a und mit einer kombinierten Beschleunigungssensoreinheit 23a. Die Einzelelemente 1'a und 23a können dabei voneinander hermetisch getrennte Bereiche innerhalb des gemeinsamen Chips 123a einnehmen, die unterschiedliche Drücke einschließen. Die jeweilige Regelungselektronik befindet sich auf separaten Einheiten 1'b, 23b und ist mit dem Sensorelement 123a in einem gemeinsamen Gehäuse 123c untergebracht.

Fig. 4 zeigt ein weiteres Element, das nicht Teil der Erfindung ist. Das Bauelement 100 weist eine Kombination eines Drehratensensors 1'a mit einer kombinierten Beschleunigungssensoreinheit 23a auf, beispielsweise einer Kombination 23a zur Messung hoher Beschleunigungswerte und niedriger Beschleunigungswerte in einer Einheit. Die Einzelelemente 1'a und 23a können dabei voneinander hermetisch getrennte Bereiche innerhalb des gemeinsamen Chips 123a einnehmen, die unterschiedliche Drücke einschließen, um auf diese Weise unterschiedliche Ansprechcharakteristiken bereitzustellen. Die Regelungselektronik für alle Einzelelemente 23a, 1'a befindet sich auf einer einzigen Einheit 123b und ist mit dem Sensorelement 123a in einem gemeinsamen Gehäuse 123c des Bauelementes 100 untergebracht.

In Fig. 2, Fig. 3 und 4 ist innerhalb des Gehäuses 123c des Bauelementes 100 jeweils mindestens ein mikromechanisches Element 123a und mindestens eine Regelungseinrichtung 1'b, 2'b, 3'b, 23b, 123b angeordnet. Das mikromechanische Element 123a weist mindestens zwei Einzelsensorelemente 1'a, 2'a, 3'a, 23a auf. Jedem Einzelsensorelement 1'a, 2'a, 3'a, 23a kann jeweils eine Regelungselektronikeinheit 1'b, 2'b, 3'b, 23b, 123b zugeordnet werden. Hierbei steht das mikromechanische Element 123a für mindestens zwei Messaufgaben zur Verfügung, so dass mindestens eine Regelungseinrichtung 1'b, 2'b, 3'b, 23b, 123b mit dem mikromechanischen Element 123a verbunden ist.

Das mikromechanische Element 123a und die Regelungseinrichtungen 1'b, 2'b, 3'b, 23b, 123b sind jeweils über eine erste Anschlussgeometrie 11 elektrisch miteinander verbunden. Die Regelungseinrichtungen 1'b, 2'b, 3'b, 23b, 123b weisen jeweils eine zweite Anschlussgeometrie 12 auf, die mit einer dritten Anschlussgeometrie 13 des Bauelementes 100 elektrisch in Verbindung steht. Mit der dritten Anschlussgeometrie 13 kann das Bauelement 100 mit einer äußeren elektrischen Beschaltung kontaktiert werden.

### Bezugszeichenliste:

- 1a, 2a, 3a,: mikromechanisches Element
- 1b, 2b, 3b: mikromechanisches Element
- 1'a, 2'a, 3'a, 23a, 123a: mikromechanisches Element
- 1'b, 2'b, 3'b, 23b, 123b: Regelungselektronikeinheit
- 1c, 2c, 3c, 123c: Gehäuse
- 11: erste Anschlussgeometrie
- 12: zweite Anschlussgeometrie
- 13: dritte Anschlussgeometrie
- 100, 101, 102, 103: Bauelement

## Patentansprüche

1. Mikromechanisches Element (123a) aufweisend eine Mehrzahl von Einzelsensorelementen (1'a, 2'a, 3'a, 23a), wobei ein erstes Einzelsensorelement (1'a) ein Drehratensensorelement (1'a), ein zweites Einzelsensorelement ein Beschleunigungssensorelement (2'a) mit niedrigem Messbereich und ein drittes Einzelsensorelement ein Beschleunigungssensorelement (3'a) mit hohem Messbereich ist, wobei die Einzelsensorelemente (1'a, 2'a, 3'a, 23a) jeweils in hermetisch voneinander getrennten Bereichen des mikromechanischen Elementes (123a) angeordnet sind.

2. Mikromechanisches Element (123a) nach Anspruch 1, wobei die Bereiche unterschiedliche Drücke aufweisen.

3. Bauelement (100) zur Messung von mindestens zwei physikalischen Messgrößen aufweisend
- ein mikromechanisches Element (123a) nach Anspruch 1;
- mindestens eine Regelungselektronikeinheit (1'b, 2'b, 3'b), die mit dem mikromechanischen Element (123a) elektrisch verbindbar ist;
- wobei das mikromechanische Element (123a) und die Regelungselektronikeinheit (1'b, 2'b, 3'b) in einem gemeinsamen Gehäuse (123c) angeordnet sind.

4. Bauelement (100) nach Anspruch 3, wobei mindestens ein Einzelsensorelement (1'a, 2'a, 3'a) über eine erste Anschlussgeometrie (11) mit der Regelungselektronikeinheit (1'b, 2'b, 3'b) innerhalb des Gehäuses (123c) elektrisch verbunden ist.

5. Bauelement (100) nach Anspruch 4, wobei die Regelungselektronikeinheit (1'b, 2'b, 3'b) eine zweite Anschlussgeometrie (12) aufweist, die mit einer dritten Anschlussgeometrie (13) des Bauelementes (100) elektrisch verbunden ist.

6. Bauelement (100) nach einem der Ansprüche 3 bis 5, wobei das mikromechanische Element (123a) geometrisch mittig zwischen einer ersten Regelungselektronikeinheit (1'b, 2'b, 3'b) und einer zweiten Regelungselektronikeinheit (1'b, 2'b, 3'b) angeordnet ist.

7. Verfahren zum Herstellen eines Bauelementes (100) aufweisend:
- Bereitstellen eines Bauelementes (100) aufweisend ein mikromechanisches Element (123a) mit einer Mehrzahl von Einzelsensorelementen (1'a, 2'a, 3'a, 23a), wobei ein erstes Einzelsensorelement (1'a) ein Drehratensensorelement 1'a, ein zweites Einzelsensorelement ein Beschleunigungssensorelement 2'a mit niedrigem Messbereich 2a und ein drittes Einzelsensorelement ein Beschleunigungssensorelement (3'a) mit hohem Messbereich ist, , wobei die Einzelsensorelemente (1'a, 2'a, 3'a, 23a) in hermetisch voneinander getrennten Bereichen des mikromechanischen Elementes (123a) angeordnet sind;
- Bereitstellen von mindestens einer Regelungselektronikeinheit (1'b, 2'b, 3'b);
- elektrisches Verbinden des mikromechanischen Elementes (123a) mit der Regelungselektronikeinheit (1'b, 2'b, 3'b); und
- Anordnen des mikromechanischen Elements (123a) und der Regelungselektronikeinheit (1'b, 2'b, 3'b) in einem gemeinsamen Gehäuse (123c).

## Claims

1. Micromechanical element (123a) comprising a plurality of individual sensor elements (1'a, 2'a, 3'a, 23a), wherein a first individual sensor element (1'a) is a rotational rate sensor element (1'a), a second individual sensor element is an acceleration sensor element (2'a) with a low measurement range and a third individual sensor element is an acceleration sensor element (3'a) with a high measurement range, wherein the individual sensor elements (1'a, 2'a, 3'a, 23a) are each arranged in regions of the micromechanical element (123a) which are separated from one another hermetically.

2. Micromechanical element (123a) according to Claim 1, wherein the regions have different pressures.

3. Component (100) for measuring at least two physical measurement variables comprising
- a micromechanical element (123a) according to Claim 1;
- at least one control electronics unit (1'b, 2'b, 3'b) which can be connected electrically to the micromechanical element (123a);
- wherein the micromechanical element (123a) and the control electronics unit (1'b, 2'b, 3'b) are arranged in a common housing (123c).

4. Component (100) according to Claim 3, wherein at least one individual sensor element (1'a, 2'a, 3'a) is connected electrically to the control electronics unit (1'b, 2'b, 3'b) inside the housing (123c) via a first connection geometry (11).

5. Component (100) according to Claim 4, wherein the control electronics unit (1'b, 2'b, 3'b) has a second connection geometry (12) which is connected electrically to a third connection geometry (13) of the component (100) .

6. Component (100) according to one of Claims 3 to 5, wherein the micromechanical element (123a) is arranged geometrically centrally between a first control electronics unit (1'b, 2'b, 3'b) and a second control electronics unit (1'b, 2'b, 3'b).

7. Method for manufacturing a component (100) comprising:
- making available a component (100) comprising a micromechanical element (123a) having a plurality of individual sensor elements (1'a, 2'a, 3'a, 23a), wherein a first individual sensor element (1'a) is a rotational rate sensor element (1'a), a second individual sensor element is an acceleration sensor element (2'a) with a low measurement range (2a) and a third individual sensor element is an acceleration sensor element (3'a) with a high measurement range, wherein the individual sensor elements (1'a, 2'a, 3'a, 23a) are each arranged in regions of the micromechanical element (123a) which are separated from one another hermetically;
- making available at least one control electronics unit (1'b, 2'b, 3'b);
- electrically connecting the micromechanical element (123a) to the control electronics unit (1'b, 2'b, 3'b); and
- arranging the micromechanical element (123a) and the control electronics unit (1'b, 2'b, 3'b) in a common housing (123c).

## Revendications

1. Elément micromécanique (123a) présentant une pluralité d'éléments capteurs individuels (1'a, 2'a, 3'a, 23a), un premier élément capteur individuel (1'a) étant un élément capteur de vitesse de rotation (1'a), un deuxième élément capteur individuel étant un élément capteur d'accélération (2'a) à plage de mesure basse, et un troisième élément capteur individuel étant un élément capteur d'accélération (3'a) à plage de mesure haute, les éléments capteurs individuels (1'a, 2'a, 3'a, 23a) étant disposés respectivement dans des zones de l'élément micromécanique (123a) séparées hermétiquement les unes des autres.

2. Elément micromécanique (123a) selon la revendication 1, dans lequel les zones présentent différentes pressions.

3. Composant (100) permettant de mesurer au moins deux grandeurs de mesure physiques, présentant
- un élément micromécanique (123a) selon la revendication 1 ;
- au moins une unité électronique de régulation (1'b, 2'b, 3'b) qui peut être reliée électriquement à l'élément micromécanique (123a) ;
- l'élément micromécanique (123a) et l'unité électronique de régulation (1'b, 2'b, 3'b) étant disposés dans un boîtier commun (123c).

4. Composant (100) selon la revendication 3, dans lequel au moins un élément capteur individuel (1'a, 2'a, 3'a) est relié électriquement par une première géométrie de connexion (11) à l'unité électronique de régulation (1'b, 2'b, 3'b) à l'intérieur du boîtier (123c) .

5. Composant (100) selon la revendication 4, dans lequel l'unité électronique de régulation (1'b, 2'b, 3'b) présente une deuxième géométrie de connexion (12) qui est reliée électriquement à une troisième géométrie de connexion (13) du composant (100).

6. Composant (100) selon l'une quelconque des revendications 3 à 5, dans lequel l'élément micromécanique (123a) est disposé au centre géométrique entre une première unité électronique de régulation (1'b, 2'b, 3'b) et une deuxième unité électronique de régulation (1'b, 2'b, 3'b).

7. Procédé de fabrication d'un composant (100), présentant les étapes consistant à :
- prévoir un composant (100) qui présente un élément micromécanique (123a) doté d'une pluralité d'éléments capteurs individuels (1'a, 2'a, 3'a, 23a), un premier élément capteur individuel (1'a) étant un élément capteur de vitesse de rotation 1'a, un deuxième élément capteur individuel étant un élément capteur d'accélération 2'a à plage de mesure basse 2a, et un troisième élément capteur individuel étant un élément capteur d'accélération (3'a) à plage de mesure haute, les éléments capteurs individuels (1'a, 2'a, 3'a, 23a) étant disposés dans des zones de l'élément micromécanique (123a) séparées hermétiquement les unes des autres ;
- prévoir au moins une unité électronique de régulation (1'b, 2'b, 3'b) ;
- relier électriquement l'élément micromécanique (123a) à l'unité électronique de régulation (1'b, 2'b, 3'b) ; et
- disposer l'élément micromécanique (123a) et l'unité électronique de régulation (1'b, 2'b, 3'b) dans un boîtier commun (123c).
